# EUROPÄISCHE PATENTANMELDUNG

(11) **EP 1 070 769 A1**
(43) Veröffentlichungstag der Anmeldung: **24.01.2001**
(21) Anmeldenummer: 00810534.8
(22) Anmeldetag: 19.06.2000
(51) Int. Cl.: C23C 30/00, C23C 4/00, C23C 14/04, C23C 16/04, F01D 5/28

(54) **Verfahren zum Beschichten einer lokal unterschiedlich beanspruchten Komponente**

(30) Priorität: 22.07.1999 DE 19934418
(71) Anmelder: ALSTOM POWER (Schweiz) AG, 5401 Baden (CH)
(72) Erfinder: Täck, Ulrike, 5400 Baden (CH)

(57) **Zusammenfassung**

Verfahren zum Beschichten einer lokal unterschiedlich beanspruchten Komponente aus einem Grundmaterial (A) mit einer Schutzschicht (2), dadurch gekennzeichnet, dass die Schutzschicht (2) aus verschiedenen Materialien (B,C,D) besteht, wobei die verschiedenen Materialien (B,C,D) auf verschiedene Bereiche des Grundmaterials (A) aufgetragen werden, und die Bereiche des Grundmaterials (A), welche nicht mit einem bestimmten Material (B,C,D) beschichtet werden sollen, während der Beschichtung eines bestimmten anderen Bereichs maskiert (6) werden können. In einem Ausführungsbeispiel handelt es sich um eine Turbinenschaufel (3) aus einer Nickelbasis-Superlegierung, welche mit einer Schutzschicht (2) aus MCrAIY beschichtet ist.

## Beschreibung

### TECHNISCHES GEBIET

Die Erfindung betrifft ein Verfahren zum Beschichten einer lokal unterschiedlich beanspruchten Komponente.

### STAND DER TECHNIK

Es ist allgemein und zahlreich bekannt, Turbinenschaufeln einer Gasturbine mit Schutzschichten zu versehen, um die Turbinenschaufel vor den thermischen Beanspruchungen während des Betriebes zu schützen und die Lebensdauer zu verlängern. Allgemein ist bekannt, die Turbinenschaufel mit einer metallischen Legierung bestehend aus MCrAIY zu versehen, wobei M für die Elemente Ni, Cr, Fe stehen kann. In der Regel wird zusätzlich eine zweite Schicht aus TBC (Thermal Barrier Coating) aufgebracht. Nachteilig bei diesem Stand der Technik ist allerdings, dass die Turbinenschaufeln an einigen Stellen weniger geschützt werden als an anderen, da die Temperaturverhältnisse und damit die Abnutzung, Wärmespannungen und Oxidation nicht an allen Stellen der Turbinenschaufel gleich ist.

### DARSTELLUNG DER ERFINDUNG

Es ist Ziel der Erfindung, eine Verfahren zum Beschichten einer lokal unterschiedlich beanspruchten Komponente zu schaffen, mit dem es möglich ist, die Komponente vor den lokal unterschiedlichen externen Beanspruchungen verbessert zu schützen. Erfindungsgemäss wird die Aufgabe dadurch gelöst, dass die Schutzschicht aus verschiedenen Materialien besteht, wobei die verschiedenen Materialien auf lokal unterschiedlich beanspruchte Bereiche des Grundmaterials aufgetragen werden. Bei einer Ausführungsform kann es sich beispielsweise um eine Turbinenschaufel einer Gasturbine aus einer Nickelbasis-Superlegierung mit einer Schutzschicht aus MCrAIY handeln. Mit dieser Art der Beschichtung ist es verbessert möglich, den unterschiedlich externen Beanspruchungen durch beispielsweise Temperatureinwirkung entgegenzuwirken, was zu einer grösseren Lebensdauer der beanspruchten Komponente führt.

### KURZE BESCHREIBUNG DER ZEICHNUNGEN

Es zeigen:
- **Fig. 1a**: ein beispielhaftes rundes Grundmaterial mit einer Schutzschicht aus zwei verschiedenen Materialien in Abhängigkeit einer extern unterschiedlichen Beanspruchung über die Höhe des Grundmaterials,
- **Fig. 1b**: ein beispielhaftes rundes Grundmaterial mit einer Schutzschicht aus zwei verschiedenen Materialien in Abhängigkeit einer extern unterschiedlichen Beanspruchung über die Breite des Grundmaterials,
- **Fig. 1c**: ein beispielhaftes rundes Grundmaterial mit einer Schutzschicht aus drei verschiedenen Materialien in Abhängigkeit einer extern unterschiedlichen Beanspruchung über die Höhe des Grundmaterials,
- **Fig. 1d**: ein beispielhaftes rundes Grundmaterial mit einer Schutzschicht aus drei verschiedenen Materialien in Abhängigkeit einer extern unterschiedlichen Beanspruchung über die Breite des Grundmaterials,
- **Fig. 1e**: ein beispielhaftes rundes Grundmaterial mit einer Schutzschicht aus drei verschiedenen Materialien mit lokal unterschiedlichen, externen Beanspruchungen auf der Oberfläche des Grundmaterials,
- **Fig. 2**: einen Teilschnitt durch das Ausführungsbeispiel der Figur 1 mit einer Schutzschicht aus zwei verschiedenen Materialien,
- **Fig. 2a**: eine Ausführungsform des Details II der Figur 2 mit einer klaren Grenze zwischen den Materialien B und C,
- **Fig. 2b**: eine zweite Ausführungsform des Details II der Figur 2 mit einem Übergangsbereich zwischen den Materialien B und C,
- **Fig. 2c**: eine dritte Ausführungsform des Details II der Figur 2 mit einem Bereich, in dem sich beide Materialien B und C vermischen,
- **Fig. 3**: ein Ausführungsbeispiel einer erfindungsgemässen Turbinenschaufel mit einer Schutzschicht mit verschiedenen Materialien aus MCrAIY über die Höhe der Turbinenschaufel,
- **Fig. 3a**: eine schematische Ansicht auf das Ausführungsbeispiel aus Figur 3 mit Grundmaterial und zwei verschiedenen Materialien als Schutzschicht,
- **Fig. 3b**: eine schematische Ansicht auf das Ausführungsbeispiel aus Figur 3 mit Grundmaterial mit einem Beschichtungsmaterial und einem zweiten lokal aufgetragen Material,
- **Fig. 4a**: schematische Darstellung des ersten Verfahrensschritts des erfindungsgemässen Beschichtsverfahrens mit einer Beschichtung eines Materials auf einem bestimmten Bereich eines Grundmaterials,
- **Fig. 4b**: schematische Darstellung des zweiten Verfahrensschritts des erfindungsgemässen Beschichtsverfahrens mit einem zweiten Material auf einem bestimmten, anderen Bereich des Grundmaterials,
- **Fig. 5a**: schematische Darstellung eines Beschichtsvorgangs auf einem bestimmten Bereich eines Grundmaterials als ersten Verfahrensschritt des erfindungsgemässen Verfahrens mit einer Maskierung des Bereiches, welcher nicht beschichtet werden soll und
- **Fig. 5b**: schematische Darstellung eines Beschichtsvorgangs auf einem bestimmten Bereich eines Grundmaterials als zweiten Verfahrensschritt des erfindungsgemässen Verfahrens mit einer Maskierung des Bereiches, welcher bereits beschichtet worden ist und nicht mehr beschichtet werden soll.

Es werden nur die für die Erfindung wesentlichen Elemente dargestellt. Gleiche Elemente in unterschiedlichen Figuren sind gleich bezeichnet.

### WEG ZUR AUSFÜHRUNG DER ERFINDUNG

Die Erfindung bezieht sich auf ein Verfahren zum Beschichten eines Grundmaterials mit einer Schutzschicht aus verschiedenen Materialien.

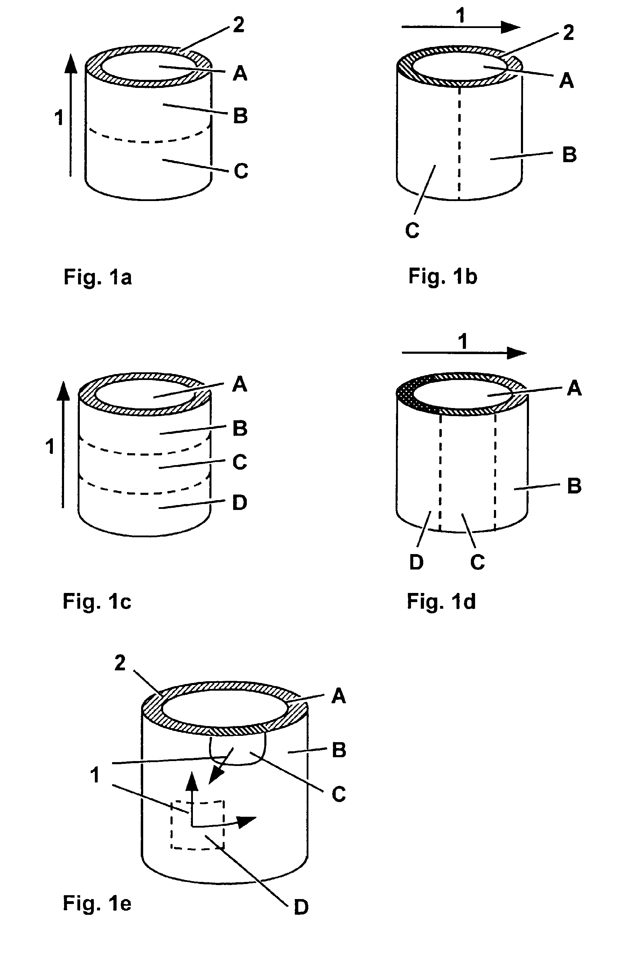

In der Figur 1a ist ein beispielsweise rundes Grundmaterial A mit einer Schutzschicht 2 dargestellt. Auf das Grundmaterial A wirkt eine externe Beanspruchung 1, welche über die Höhe des Grundmaterials in der dargestellten Pfeilrichtung variiert. Um der variablen Beanspruchung 1 Rechnung zu tragen, besteht die das Grundmaterial A umgebende Schutzschicht 2 aus zwei Materialien B und C, welche über die Höhe des Grundmaterials A nebeneinander aufgetragen sind. Wie in der Figur 1b ersichtlich ist, können die Materialien auch über die Breite aufgetragen sein, sofern die externe variable Beanspruchung 1 dies notwendig werden lässt. Die Figuren 1c und 1d zeigen eine Ausführungsform mit drei verschiedenen Materialien B,C,D als Schutzschicht 2 entsprechend einer externen variablen Beanspruchung 1. Bei der externen Beanspruchung kann es sich allgemein um verschiedene Temperaturen, um Korrosion, um Oxidation oder um mechanische (Wärme-)spannungen handeln. Bei den Materialien B,C kann es sich beispielsweise um metallische Legierungen, keramisches Material oder um ein Polymer handeln.

Es ist auch denkbar bei lokal unterschiedlichen Beanspruchungen 1, eine Schutzschicht 2 aus den Materialien B,C,D an den lokalen Stellen auf das Grundmaterial A entsprechend der lokalen externen Beanspruchung 1 aufzutragen. Dies ist in der Figur 1e dargestellt.

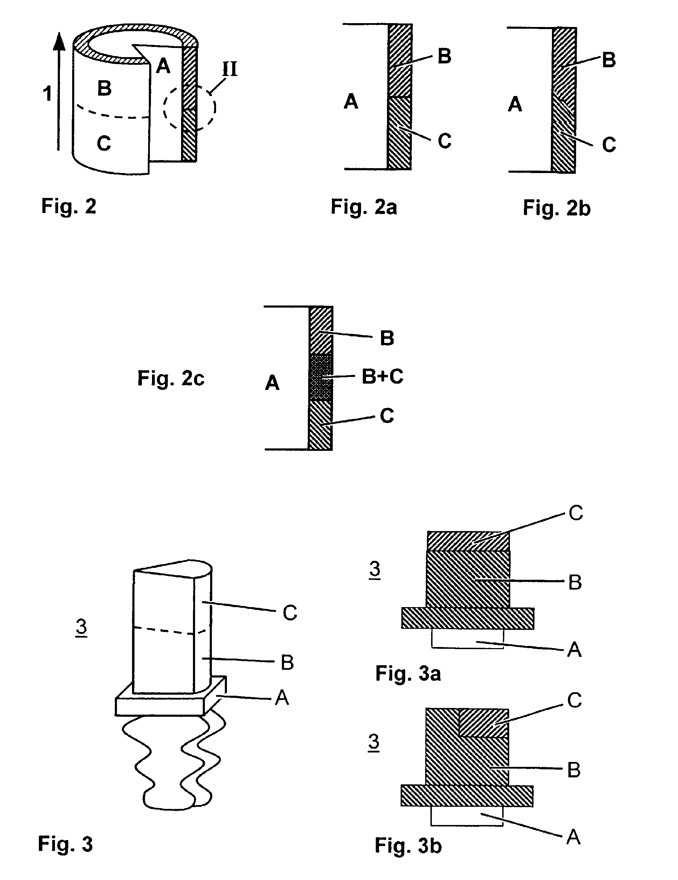

Die Figur 2 zeigt einen Teilschnitt des Ausführungsbeispiels der Figur 1a und die Figuren 2a-c verschiedene Ausführungsmöglichkeiten des Details II der Figur 2 mit dem Übergangsbereich zwischen den beiden Materialien B und C der Schutzschicht 2. Figur 2a zeigt eine klare Grenze zwischen den Materialien B und C, die Figur 2b einen sich überlappenden Bereich zwischen den Materialien B und C und die Figur 2c zeigt einen Übergangsbereich, in dem sich beide Materialien B und C mischen. Diese prinzipielle Darstellung gilt für alle in dieser Beschreibung erwähnten Materialien einer Schutzschicht 2, wobei bei verschiedenen verwendeten Materialien mehrere Übergangsbereiche in einer Schutzschicht 2 möglich sind. Vorteilhaft ist der Übergang zwischen den verschiedenen Materialien B,C der Schutzschicht kontinuierlich, da dies einen kontinuierlicher Übergang der mechanischen Eigenschaften bedeutet und anderenfalls Probleme bei der mechanischen Integrität der Komponente auftauchen können (z.B. extremer Spannungsgradient).

Als Ausführungsbeispiel ist in der Figur 3 eine Turbinenschaufel 3, also beispielsweise die Leit- oder Laufschaufel einer Gasturbine, dargestellt. Die Turbinenschaufel besteht aus einem Grundmaterial A, welches beispielsweise eine Nickelbasis-Superlegierung sein kann. Eine solche Superlegierung ist zum Beispiel aus der Patentschrift US 5,759,301 bekannt. Üblicherweise wird eine solche Turbinenschaufel 3 mit einer metallischen Legierung MCrAIY beschichtet, wobei es sich bei M um Cr, Ni oder Fe handeln kann. Eine solche FeCrAIY-Legierungen ist beispielsweise aus der Druckschrift US 3,528,861 bekannt. Eine andere solche MCrAIY-Legierung ist in dem Patent US 4,585,481 beschrieben. Die Turbinenschaufel 3 ist bei dem Betrieb hohen Beanspruchungen ausgesetzt, welche von der Temperatur des umgebenden Mediums abhängt. Die obere Spitze ist beispielsweise einer hohen Temperatur und dadurch einer höheren Oxidation ausgesetzt als der untere Teil der Turbinenschaufel 3, welcher zwar niedrigeren Temperaturen, aber höheren Spannungen ausgesetzt ist. Zudem ist die Turbinenschaufel 3 während des Betriebes einer stetigen Korrosion ausgesetzt. Es ist Ziel der Erfindung, verschiedene Materialien B,C für die Schutzschicht 2 in Abhängigkeit von der externen Beanspruchung 1 für verschiedene Bereiche optimal auszuwählen. Wie in den Figuren 3a und 3b ersichtlich, können unterschiedliche Bereiche auf der Oberfläche der Turbinenschaufel 3 je nach dem speziellen Anwendungsfall gewählt werden. Vorteilhaft erhöht sich die Lebensdauer einer solcher Turbinenschaufel 3, da die Schutzschicht 2 den externen Beanspruchungen 1 während des Betriebes der Turbinenschaufel 1 verbessert standhält. Allgemein können die bei der Schutzschicht verwendeten Materialien metallische Legierungen oder keramische Materialien (z.B. Y stabilisiertes Zr-Oxid, welches auch als TBC bekannt ist). Für eine aus einer Nickelbasis-Superlegierung bestehende Turbinenschaufel 3 sind verschiedene Beschichtungsverfahren 4 aus dem Stand der Technik bekannt, um eine Schutzschicht 2 aus MCrAIY aufzutragen, beispielsweise aus US 4,152,223 oder US 4,246,326 ist ein Plasma-Spritz-Verfahren bekannt, ein elektrisches oder chemisches Aufdampf-Verfahren ist aber auch möglich. Andere, gleichwertige Verfahren sind ebenso denkbar.

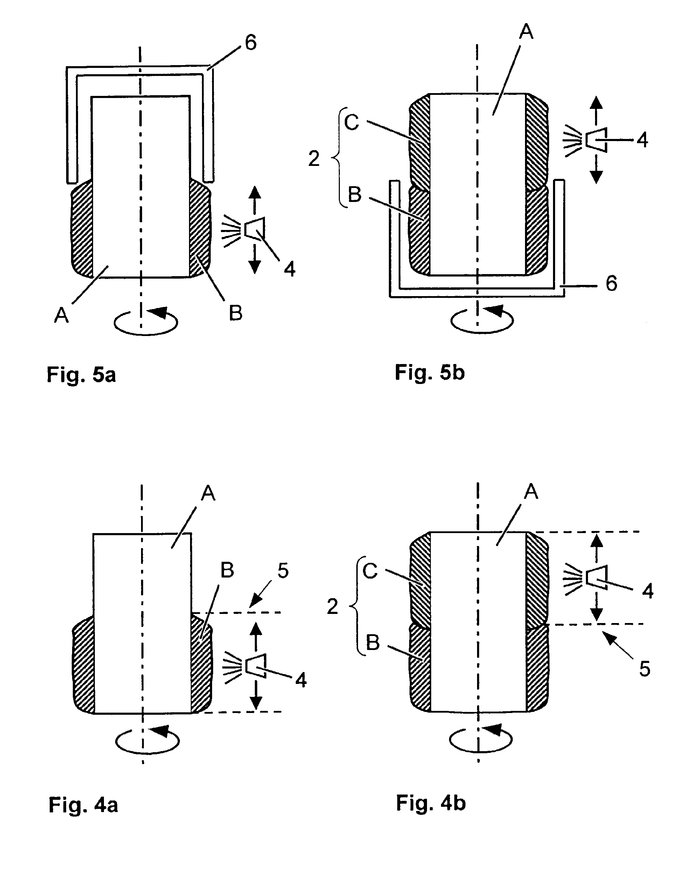

Wie in der Figur 4a und 4b dargestellt, wird erfindungsgemäss das Grundmaterial A innerhalb bestimmter Begrenzungen 5 mit jeweils einer der verschiedenen Materialien B,C beschichtet. In der Figur 4a wird im unteren Bereich des Grundmaterials A das Material B durch ein geeignetes Beschichtungsmittel 4 aufgebracht, in der Figur 4b wird in einem zweiten Verfahrensschritt im oberen Bereich des Grundmaterials das Material C ebenfalls durch ein geeignetes Beschichtungsmittel 4 aufgebracht. Die Materialien B,C werden entsprechend ihren Eigenschaften und einer späteren Beanspruchung der Komponente während des Betriebes gewählt. Die Anzahl der verwendeten Materialien B,C und die lokale Ausdehnung der Beschichtung auf der Oberfläche des Grundmaterials 1 sind in der Figur 4a und 4b nur beispielhaft gewählt und können in Abhängigkeit von der Anwendung der beschichteten Komponente variieren.

Die Figuren 5a und 5b zeigen den Beschichtungsvorgang der Komponente A in einem zweiten Ausführungsbeispiel. Analog zu den Figuren 4a und 4b wird zuerst das Material B und danach das Material C aufgetragen. Im Gegensatz dazu werden aber in den Figuren 5a und 5b die Bereiche auf der Oberfläche, welche mit einem bestimmten Material nicht beschichtet werden sollen oder bereits beschichtet worden sind, mit einer geeigneten Maskierung 6 abdeckt. In der Figur 6a wird der obere Bereich des Grundmaterials A mit der Maskierung 6 während des Beschichtungsvorgangs von Material B verdeckt, und in der Figur 6b der bereits mit B maskierte Teil und dann das Material C aufgetragen. Die Geometrie der Maskierung 6 kann für verschiedene Bereiche, welche verdeckt werden sollen, variieren.

### BEZUGSZEICHENLISTE

- **A**: Grundmaterial
- **B,C,D**: verschiedene Materialien der Schutzschicht 2

- **1**: Beanspruchung
- **2**: Schutzschicht
- **3**: Turbinenschaufel
- **4**: Beschichtungsmittel
- **5**: Begrenzung
- **6**: Maskierung

## Patentansprüche

1. Verfahren zum Beschichten einer lokal unterschiedlich beanspruchten Komponente aus einem Grundmaterial (A) mit einer Schutzschicht (2),
dadurch gekennzeichnet, dass
die Schutzschicht (2) aus verschiedenen Materialien (B,C,D) besteht, wobei die verschiedenen Materialien (B,C,D) auf unterschiedliche beanspruchte Bereiche des Grundmaterials (A) aufgetragen werden.

2. Verfahren nach Anspruch 1,
dadurch gekennzeichnet, dass
die Bereiche des Grundmaterials (A), welche nicht mit einem bestimmten Material (B,C,D) beschichtet werden sollen, während der Beschichtung eines bestimmten anderen Bereichs maskiert (6) werden.

3. Verfahren nach Anspruch 1 oder 2,
dadurch gekennzeichnet, dass
die lokal unterschiedlich beanspruchte Komponente, auf welche die Schutzschicht (2) aufgetragen wird, eine Turbinenschaufel (3) einer Gasturbine ist.

4. Verfahren nach Anspruch 3,
dadurch gekennzeichnet, dass
die lokal unterschiedlich beanspruchte Komponente, auf welche die Schutzschicht (2) aufgetragen wird, die Turbinenschaufel (3) einer Gasturbine ist, welche aus einer Nickelbasis-Superlegierung besteht.

5. Verfahren nach Anspruch 3 oder 4,
dadurch gekennzeichnet, dass
die Schutzschicht (2), welche auf die Turbinenschaufel (3) aufgetragen wird, aus MCrAIY besteht.

6. Turbinenschaufel (3) einer Gasturbine mit einer Schutzschicht (2) aus MCrAIY gefertigt nach dem Verfahren gemäss Anspruch 5,
dadurch gekennzeichnet, dass
verschiedene Bereiche der Schutzschicht (2) der Turbinenschaufel (3) mit verschiedenen Materialien (B,C,D) aus MCrAIY beschichtet sind.
